# EUROPEAN PATENT APPLICATION

(11) **EP 4 513 557 A1**
(43) Date of publication of application: **26.02.2025**
(21) Application number: 24151530.3
(22) Date of filing: 12.01.2024
(51) Int. Cl.: H01L 25/07, H02M 7/00

(54) **POWER SEMICONDUCTOR MODULE AND A METHOD OF FORMING A POWER SEMICONDUCTOR MODULE**

(30) Priority: 23.08.2023 KR 20230110703
(71) Applicant: LX Semicon Co., Ltd., Daejeon 34027 (KR)
(72) Inventor: Lee, In Hwan, 34027 Yuseong-gu, Daejeon (KR); Kim, Deog Soo, 34027 Yuseong-gu, Daejeon (KR); Kim, Tae Ryong, 34027 Yuseong-gu, Daejeon (KR)
(74) Representative: Ter Meer Steinmeister & Partner

(57) **Abstract**

A power semiconductor module is provided. A power semiconductor module comprises a first substrate, a second substrate formed over the first substrate, a conductive member disposed between the first substrate and the second substrate, a first power semiconductor device disposed between the first substrate and the conductive member, and a second power semiconductor device disposed between the conductive member and the second substrate. The conductive member is electrically connected to the first power semiconductor device and the second power semiconductor device.

## Description

### TECHNICAL FIELD

Disclosed are embodiments related to a power semiconductor module and a method of forming a power semiconductor module.

### BACKGROUND

As compared to a system semiconductor or a memory that processes and stores information or signals, a power semiconductor is a component that converts, stores, distributes, and/or controls power that is provided to electronic devices. The power semiconductor device is widely used in many electronic products.

In recent years, in line with the global trend of strengthening environmental protection, electric or hydrogen-based eco-friendly vehicles increasingly replace existing fossil fuel-based vehicles. Numerous power semiconductor devices are used in these eco-friendly vehicles. Examples of the eco-friendly vehicle include a hybrid electric vehicle (HEV), a plug-in hybrid vehicle (PHEV), an electric vehicle (EV), a fuel cell electric vehicle (PCEV) or the like.

Existing silicon (Si) power semiconductor devices have low power, low dielectric breakdown characteristics, and a low thermal conductivity.

Accordingly, research on a power semiconductor device based on a semiconductor compound having an energy band gap that is about three times higher than that of the Si power semiconductor device has been actively conducted. The power semiconductor devices based on such semiconductor compound has high power, high dielectric breakdown characteristics, and a high thermal conductivity.

Recently, a power semiconductor module in which a plurality of power semiconductor devices are packaged has been widely studied, and a power converter having such power semiconductor module is applied to various technical fields.

A plurality of power semiconductor devices comprised in a power semiconductor module may be connected in series or parallel. In such case, when each power semiconductor device is turned off, stray inductance may be formed in the corresponding power semiconductor device, and. The stray inductance is greatly affected by the electrical connection path of the power semiconductor device. More specifically, for example, as the length of the electrical connection path between power semiconductor devices increases, the length of the current path increases, and the stray inductance increases due to the increased length of the current path.

Since the stray inductance impedes the flow of current, and thus impedes high-power output of the power semiconductor device, it needs to be minimized or eliminated. In particular, when the stray inductance increases, instantaneous voltage overshooting may occur. When the overshooting voltage exceeds the withstand voltage of the power semiconductor device, the power semiconductor device can be damaged or a switching loss of the power second semiconductor device may occur. Therefore, there is a need for a technical solution for minimizing or eliminating the stray inductance.

Furthermore, as the required high-power output of the power semiconductor device increases, the size of the power semiconductor device may also need to be increased. However, there is a strong demand to reduce the size of a product in which a plurality of power semiconductor devices are adopted. Therefore, there is also a need to develop a power semiconductor module that allows the size of a product including the power semiconductor module small or the same while increasing the high-power output of the power semiconductor device per unit area.

### SUMMARY

Some embodiments of this disclosure are for solving the above described problems.

More specifically, one object of some embodiments is to provide a power semiconductor module and a method of forming a power semiconductor module capable of preventing damage to a power semiconductor device. Another object of some embodiments is to provide a power semiconductor module and a method of forming a power semiconductor module capable of reducing the switching loss of a power semiconductor device. Further object of some embodiments is to provide a power semiconductor module and a method of forming a power semiconductor module capable of increasing high-power output per unit area. Further object of some embodiments is to provide a power semiconductor module and a method of forming a power semiconductor module with a reduced size.

At least one of these objects is solved by the features of the independent claims. The technical problems of the embodiments are not limited to those described above, and may include those that can be grasped through the description below.

According to an aspect of the present disclosure, a power semiconductor module comprises: a first substrate; a second substrate formed over the first substrate; a conductive member disposed between the first substrate and the second substrate; a first power semiconductor device disposed between the first substrate and the conductive member; and a second power semiconductor device disposed between the conductive member and the second substrate, wherein the conductive member is electrically connected to the first power semiconductor device and the second power semiconductor device.

The first power semiconductor device and the second power semiconductor device may at least partially overlap.

The first power semiconductor device and the second power semiconductor device may be electrically connected in series.

The conductive member may comprise: a second part; and a connection part connected to the second part. The second power semiconductor device may be disposed on a surface of the second part.

The conductive member may comprise: a first part positioned lower than the second part and connected to the connection part. The conductive member may include a recess formed by the first part, the connection part and the second part. The first power semiconductor device may be disposed within the recess.

The first part may be fixed to the first substrate.

The power semiconductor module may further comprise a spacer disposed between the first power semiconductor device and the conductive member.

The spacer may extend from the conductive member toward the first power semiconductor device.

The first power semiconductor device may comprise a first gate electrode, a first source electrode, and a first drain electrode. The first gate electrode may be electrically connected to the first substrate using a wire. The first source electrode may be electrically connected to the conductive member. The first drain electrode may be electrically connected to the first substrate.

An upper surface of the spacer may be at a higher position as compared to a position of the uppermost side of the wire.

The conductive member may include an opening via which the wire is disposed.

The second power semiconductor device may comprise a second gate electrode, a second source electrode, and a second drain electrode. The second gate electrode and the second source electrode may be electrically connected to the second substrate. The second drain electrode may be electrically connected to the conductive member.

The first substrate may comprise a first conductive layer, a first insulating layer, and a second conductive layer. The first conductive layer may comprise a plurality of first signal patterns. The wire may be connected to one of the plurality of first signal patterns. The first drain electrode may be connected to another one of the plurality of first signal patterns.

The second substrate may comprise a third conductive layer, a second insulating layer and a fourth conductive layer. The third conductive layer may comprise a plurality of second signal patterns. The second gate electrode i may be s connected to one of the plurality of second signal patterns. The second source electrode may be connected to another one of the plurality of second signal patterns.

The power semiconductor module may comprise: a plurality of first power semiconductor devices including the first power semiconductor device. The plurality of first power semiconductor devices may be connected in parallel between the first substrate and the conductive member.

The power semiconductor module may comprise: a plurality of second power semiconductor devices including the second power semiconductor device. The plurality of second power semiconductor devices may be connected in parallel between the conductive member and the second substrate.

Each of the plurality of first power semiconductor devices and each of the plurality of second power semiconductor devices may at least partially overlap.

A current path may be configured to be formed through the first substrate, the first power semiconductor device, the conductive member, the second power semiconductor device, and the second substrate in a sequence of the first substrate, the first power semiconductor device, the conductive member, the second power semiconductor device, and the second substrate.

According to a further aspect, a method of forming a power semiconductor module, e.g. a power semiconductor module according to any one of the herein described aspects and embodiments, comprises: forming a first substrate; forming a first power semiconductor device on the first substrate; forming a conductive member over the first power semiconductor device such that the first power semiconductor device is disposed between the first substrate and the conductive member; forming a second power semiconductor device on the conductive member; forming a second substrate over the second semiconductor member such that the second power semiconductor device is disposed between the conductive member and the second substrate, wherein the conductive member is disposed between the first substrate and the second substrate.

A current path may be configured to be formed through the first substrate, the first power semiconductor device, the conductive member, the second power semiconductor device, and the second substrate in a sequence of the first substrate, the first power semiconductor device, the conductive member, the second power semiconductor device, and the second substrate.

Each of the plurality of first power semiconductor devices and each of the plurality of second power semiconductor devices may at least partially overlap.

A current path may be configured to be formed through the first substrate, the first power semiconductor device, the conductive member, the second power semiconductor device, and the second substrate in a sequence of the first substrate, the first power semiconductor device, the conductive member, the second power semiconductor device, and the second substrate.

According to a further aspect, a method of forming a semiconductor module, e.g. a power semiconductor module according to any one of the herein described aspects and embodiments, comprises: forming a first substrate; forming a first power semiconductor device on the first substrate; forming a conductive member over the first power semiconductor device such that the first power semiconductor device is disposed between the first substrate and the conductive member; forming a second power semiconductor device on the conductive member; forming a second substrate over the second semiconductor member such that the second power semiconductor device is disposed between the conductive member and the second substrate, wherein the conductive member is disposed between the first substrate and the second substrate.

A current path may be configured to be formed through the first substrate, the first power semiconductor device, the conductive member, the second power semiconductor device, and the second substrate in a sequence of the first substrate, the first power semiconductor device, the conductive member, the second power semiconductor device, and the second substrate.

Effects of the power semiconductor module and a method of forming a power semiconductor module according to some embodiments are described below.

According to at least one of the embodiments, switching loss suppression and high-precision switching control of the power semiconductor device can be achieved.

More specifically, since, in these embodiments, a first power semiconductor device and/or a second power semiconductor device may be connected to a conductive support having a plate shape in surface contact, the contact resistance between the first power semiconductor device and/or the second power semiconductor device and the conductive support can be minimized, thereby minimizing the current losses. Accordingly, the switching loss of the first power semiconductor device or the second power semiconductor device may be prevented, thereby achieving a predetermined high-power output and high-precision switching control.

Also, according to at least one of the embodiments, damage to a power semiconductor device can be prevented.

In the power semiconductor module according to some embodiments, a first power semiconductor device and a second power semiconductor device can be vertically overlapped with a support therebetween between the first substrate and the second substrate. Since the first power semiconductor device and the second power semiconductor device are spaced apart by the thickness of the support, the separation gap between the first power semiconductor device and the second power semiconductor device can be minimized.

An electrical connection path between the first power semiconductor device and the second power semiconductor device can greatly affect the stray inductance. However, in the power semiconductor module according to some embodiments, since the separation gap between the first power semiconductor device and the second power semiconductor device can be minimized, the stray inductance can be removed or minimized. Accordingly, even when the first power semiconductor device or the second power semiconductor device is turned off, no stray inductance is generated and no overshooting voltage is generated. Therefore, damage to the first power semiconductor device or the second power semiconductor device due to the overshooting voltage can be prevented.

Furthermore, according to at least one of the embodiments, switching loss can be reduced.

The stray inductance affects the switching loss of the first power semiconductor device or the second power semiconductor device. However, in the power semiconductor module according to some embodiments, since the separation gap between the first power semiconductor device and the second power semiconductor device is minimized, the stray inductance is removed or minimized. Thus, it does not affect the switching loss of the first power semiconductor device or the second power semiconductor device, and a predetermined high-power output is possible.

Additionally, according to at least one of the embodiments, high-power output per unit area can be increased and the size can be reduced.

In the power semiconductor module according to some embodiments, a first power semiconductor device and a second power semiconductor device are vertically overlapped with a support therebetween to minimize the placement area of the first power semiconductor device and the second power semiconductor device, thereby minimizing the size of the power semiconductor module or power semiconductor device. Accordingly, since more first power semiconductor devices or second power semiconductor devices can be mounted per unit area, higher power output is possible.

Additionally, according to at least one of the embodiments, an electrical short of a wire can be prevented.

In the power semiconductor module according to some embodiments, a first power semiconductor device and a second power semiconductor device can be vertically overlapped with a support therebetween. One side of the first power semiconductor device and the first substrate can be electrically connected through a wire. A spacer can be disposed between the first power semiconductor device and the support. The spacer can prevent the wire from being electrically shorted with the support. For example, an upper surface of the spacer can be positioned higher than the uppermost side of the wire.

Additionally, according to at least one of the embodiments, high-power output can be increased.

In the power semiconductor module according to some embodiments, the first power semiconductor device and the second power semiconductor device can be vertically overlapped with a support therebetween. Since a plurality of first power semiconductor devices are provided in parallel and a plurality of second power semiconductor devices are provided in parallel with each other, current characteristics are improved and high-power output is possible.

A further scope of applicability of the embodiment will become apparent from the detailed description that follows. However, since various changes and modifications within the spirit and scope of the embodiment can be clearly understood by those skilled in the art, it should be understood that the detailed description and specific embodiment, such as preferred embodiment, are given by way of example only.

The accompanying drawings, which are incorporated herein and form part of the specification, illustrate various embodiments.

### BRIEF DESCRIPTION OF THE DRAWINGS

FIG. 1 is a circuit diagram illustrating an automotive inverter according to some embodiments.
FIG. 2 is a plan view illustrating a power semiconductor module according to some embodiments.
FIG. 3 is a cross-sectional view illustrating a power semiconductor module according to some embodiments.
FIG. 4 is a detailed cross-sectional view illustrating a power semiconductor module according to some embodiments.
FIG. 5 is a cross-sectional view illustrating a power semiconductor device according to some embodiments.
FIG. 6A shows a current path of a power semiconductor module.
FIG. 6B shows a current path of a power semiconductor module according to some embodiments.
FIG. 7A to FIG. 7E illustrate a manufacturing process of a power semiconductor module according to some embodiments.
FIG. 8 is a plan view illustrating a power semiconductor module according to some embodiments.
FIG. 9 is a cross-sectional view illustrating a power semiconductor module according to some embodiments.
FIG. 10 is a cross-sectional view illustrating a power semiconductor module according to some embodiments.
FIG. 11 is a circuit diagram illustrating an automotive inverter according to some embodiments.
FIG. 12 is a plan view illustrating a power semiconductor module according to some embodiments.
FIG. 13 is a cross-sectional view illustrating a power semiconductor module according to some embodiments.

### DETAILED DESCRIPTION

The embodiments disclosed in this specification will be described in detail with reference to the accompanying drawings. The same or similar elements are given the same reference numerals, and redundant descriptions thereof are omitted. The suffixes "module" and "unit" used in the following descriptions are used interchangeably in consideration of ease of writing the specification, and do not themselves have a meaning or role that is distinct from each other. In addition, the accompanying drawings are for easy understanding of the embodiments disclosed in this specification, and the technical idea disclosed in this specification is not limited by the accompanying drawings. Also, when an element such as a layer, a region, or a substrate is referred to as being "on" another element, this means that the element can be directly on said another element or indirectly on said another element via one or more other intermediate elements disposed between the element and said another element.

Terms including ordinal numbers, such as first and second, can be used to describe various components, but the components are not limited by the terms. The above terms are only used for the purpose of distinguishing one component from another.

Singular expressions include plural expressions unless the context clearly indicates otherwise.

In this disclosure, it should be understood that terms such as "include," "have," or "provide" are intended to designate that there is a feature, number, step, operation, component, part, or combination thereof described in the specification, but does not preclude the possibility of the presence or addition of one or more other features, numbers, steps, operations, components, parts, or combinations thereof.

According to some embodiments, a power converter is used for inverters or converters included in apparatuses such as computers, home appliances, automobiles, solar power, and smart grids. The power converter may comprise one power semiconductor module or a plurality of power semiconductor modules. A power semiconductor module may comprise one or more power semiconductor devices.

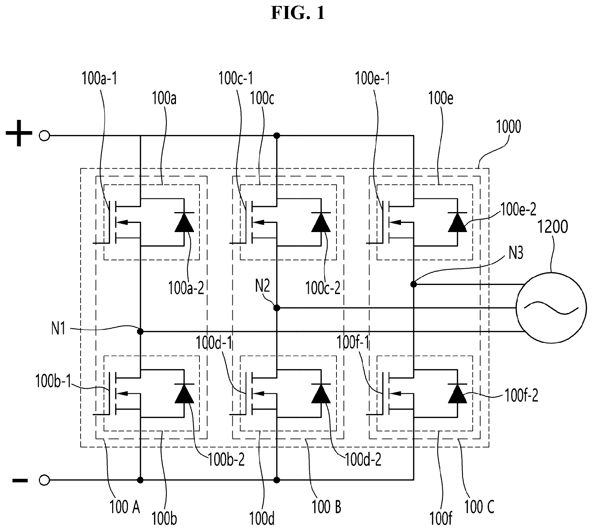

In the embodiments shown in FIGS. 1-11, an automotive inverter for driving a motor included in a vehicle is described as an apparatus including a power converter. An example of the vehicle is an eco-friendly vehicle such as HEV, PHEV, EV, PCEV or the like.

But the use of the power converter is not limited to a motor in a vehicle. The power converter can be applied to the inverters or the converters in other various technical fields described above.

In the embodiments described below with respect to FIGS. 1-11, the terms "a switching element" and the "power semiconductor device" may be used interchangeably. Similarly, the terms "a leg" and "a power semiconductor module" may be used interchangeably.

In this disclosure, a power semiconductor module may refer to a module in which at least one power semiconductor device for converting, distributing and/or controlling power input to at least one electronic device is packaged. Similarly, a power semiconductor device may refer to at least one semiconductor device for converting, distributing and/or controlling power input to at least one electronic device.

FIG. 1 is a circuit diagram illustrating an automotive inverter according to some embodiments.

Referring to FIG. 1, an automotive inverter 1000 may be configured to convert DC power into AC power and supply the converted AC power to a load 1200 to drive the load 1200. In the automotive inverter 1000, a battery can be connected to an input terminal so that DC power of the battery can be converted into AC power. Although not shown, a converter can be connected to the input terminal of the battery, and an input terminal of the converter can be connected to a charger of a charging station. In this case, AC power supplied through the charger can be converted into DC power by the converter, and the converted DC power can charge the battery. In addition, the DC power charged in the battery can be converted into AC power by the automotive inverter 1000 and can be used to drive the load.

The load 1200 can be a motor, but is not limited thereto.

The automotive inverter 1000 can comprise a 3-phase inverter -- a first phase, a second phase, and a third phase --, but is not limited thereto. In this case, there can be a phase difference of 120 degrees between the first phase, the second phase, and the third phase. The automotive inverter 1000 may comprise a plurality of legs 100A, 100B, and 100C. For example, the first leg 100A, the second leg 100B, and the third leg 100C can be connected in parallel to the load, i.e., the motor, through a first node N1, a second node N2, and a third node N3, respectively. The first leg 100A can comprise a first arm 100a and a second arm 100b connected in series with each other, and the second leg 100B can comprise a third arm 100c and a fourth arm 100d connected in series with each other, and the third leg 100C can comprise a fifth arm 100e and a sixth arm 100f connected in series with each other. Here, the first arm 100a, the third arm 100c, and the fifth arm 100e can be called an upper arm, and the second arm 100b, the fourth arm 100d, and the sixth arm 100f are called a lower arm. Each of the first arm 100a to sixth arms 100f can be referred to as a switching module or submodule.

The first arm 100a to the sixth arm 100f can comprise switching elements 100a-1, 100b-1, 100c-1, 100d-1, 100e-1, and 100f-1 and diodes 100a-2 and 100b-2, 100c-2, 100d-2, 100e-2, and 100f-2, respectively. The switching elements 100a-1, 100b-1, 100c-1, 100d-1, 100e-1, 100f-1 and the diodes 100a-2, 100b-2, 100c-2, 100d-2, 100e-2, 100f-2 can be formed simultaneously using the same semiconductor process. Each of the switching elements 100a-1, 100b-1, 100c-1, 100d-1, 100e-1, and 100f-1 can comprise at least one power semiconductor device.

In order to convert DC power into AC power by the inverter, the switching elements 100a-1, 100b-1, 100c-1, and 100d-1, 100e-1, and 100f-1 of each of the first arm 100a to the sixth arm 100f can be on/off controlled.

For example, when the first switching element 100a-1 of the first arm 100a of the first leg 100A is in an on state, the fourth switching element 100d-1 of the fourth arm 100d of the second leg 100B and/or the sixth switching element 100f-1 of the sixth arm 100f of the third leg 100C can be turned on. Accordingly, DC power can be supplied to the first phase inductor of the motor (not shown).

For example, when the second switching element 100b-1 of the second arm 100b of the second leg 100B is in an on state, the sixth switching element 100f 1 of the sixth arm 100f of the third leg 100C and/or the second switching element 100b-1 of the second arm 100b of the first leg 100A can be turned on. Accordingly, DC power can be supplied to the second phase inductor of the motor (not shown). The second phase can be delayed by 120 degrees from the first phase.

For example, when the third switching element 100c-1 of the third arm 100c of the third leg 100C is in an on state, the second switching element 100b-1 of the second arm 100b of the first leg 100A and/or the fourth switching element 100d-1 of the fourth arm 100d of the second leg 100B can be turned on. Accordingly, DC power can be supplied to the third phase inductor of the motor (not shown). The third phase can be delayed by 120 degrees from the second phase.

Accordingly, AC power can be generated by the DC power supplied to each of the first phase inductor, the second phase inductor, and the third phase inductor.

Although not shown, the switching elements of each of the first arm 100a to sixth arm 100f, that is, the power semiconductor devices 100a-1, 100b-1, 100c-1, 100d-1, 100e-1, 100f-1, may be connected in series with each other.

Alternatively, although not shown, the switching elements of each of the first arm 100a to sixth arm 100f, that is, the power semiconductor devices 100a-1, 100b-1, 100c-1, 100d-1, 100e-1, 100f-1, may be connected in parallel with each other.

the two or more of the switching elements 100a-1, 100b-1, 100c-1, 100d-1, 100e-1, and 100f-1 and the diode 100a- 2, 100b-2, 100c-2, 100d-2, 100e-2, 100f-2 constituting the first arm 100a to the sixth arm 100f can be packaged and configured as a power semiconductor module.

As an example, each of the first leg 100A, the second leg 100B, and the third leg 100C can be configured as a power semiconductor module. That is, the first arm 100a and the second arm 100b of the first leg 100A can be packaged to form a first power semiconductor module. The third arm 100c and the fourth arm 100d of the second leg 100B can be packaged to form a second power semiconductor module. The fifth arm 100e and the sixth arm 100f of the third leg 100C can be packaged to form a third power semiconductor module.

In another example, the first leg 100A, the second leg 100B, and the third leg 100C can be configured as a single power semiconductor module. That is, the first arm 100a and the second arm 100b of the first leg 100A, the third arm 100c and the fourth arm 100d of the second leg 100B, and the fifth arm 100e and the sixth arm 100f of the third leg 100C can be packaged to form a single power semiconductor module.

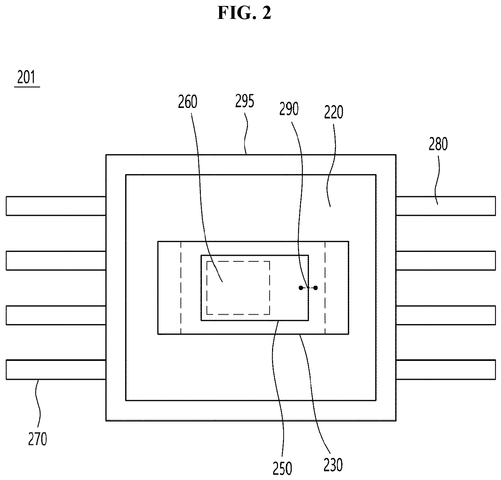

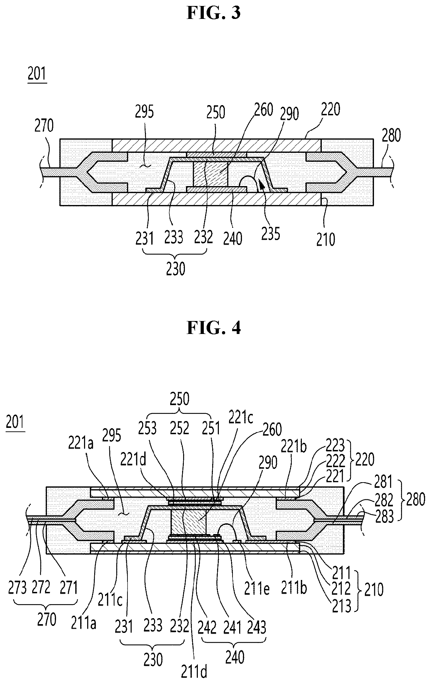

FIG. 2 is a plan view illustrating a power semiconductor module according to some embodiments. FIG. 3 is a cross-sectional view illustrating a power semiconductor module according to some embodiments.

A power semiconductor module 201 shown in FIG. 2 can be one of the first leg 100A, the second leg 100B, and the third leg 100C shown in FIG. 1. Although not shown, the power semiconductor module 201 may comprise all of the first leg 100A, the second leg 100B, and the third leg 100C.

Referring to FIG. 2 and FIG. 3, the power semiconductor module 201 may comprise a first substrate 210, a second substrate 220, a support 230, a first power semiconductor device 240, and a second power semiconductor device 250.

The second substrate 220 can be disposed on the first substrate 210, and the support 230 can be disposed between the first substrate 210 and the second substrate 220. In this case, the first power semiconductor device 240 is disposed between the first substrate 210 and the support 230, and the second power semiconductor device 250 is disposed between the support 230 and the second substrate 220.

The first power semiconductor device 240 and the second power semiconductor device 250 can be vertically overlapped. The first power semiconductor device 240 and the second power semiconductor device 250 can be vertically overlapped between the first substrate 210 and the second substrate 220. The first power semiconductor device 240 and the second power semiconductor device 250 can be vertically overlapped with the support 230 interposed therebetween. For example, the first power semiconductor device 240 can be disposed on a lower surface of a specific portion the support 230, and the second power semiconductor device 250 can be disposed on an upper surface of the specific portion of the support 230. Accordingly, the first power semiconductor device 240 and the second power semiconductor device 250 can vertically overlap in the specific portion of the support 230.

The first power semiconductor device 240 and the second power semiconductor device 250 that vertically overlap each other can be connected in series.

As described above, the power semiconductor module 201 can be composed of each or the whole of the first leg 100A, the second leg 100B, and the third leg 100C shown in FIG 1. In this case, the first power semiconductor device 240 is one of the first switching element 100a-1 of the first arm 100a, the third switching element 100c-1 of the third arm 100c, and the fifth switching element 100e-1 of the fifth arm 100e, and the second power semiconductor device 250 can be one of the second switching element 100b-1 of the second arm 100b, the fourth switching element 100d-1 of the fourth arm 100d, and the sixth switching element 100f 1 of the sixth arm 100f.

The first power semiconductor device 240 and the second power semiconductor device 250 can be any one of N-type MOSFETs (Metal Oxide Semiconductor Field Effect Transistors) and P-type MOSFETs.

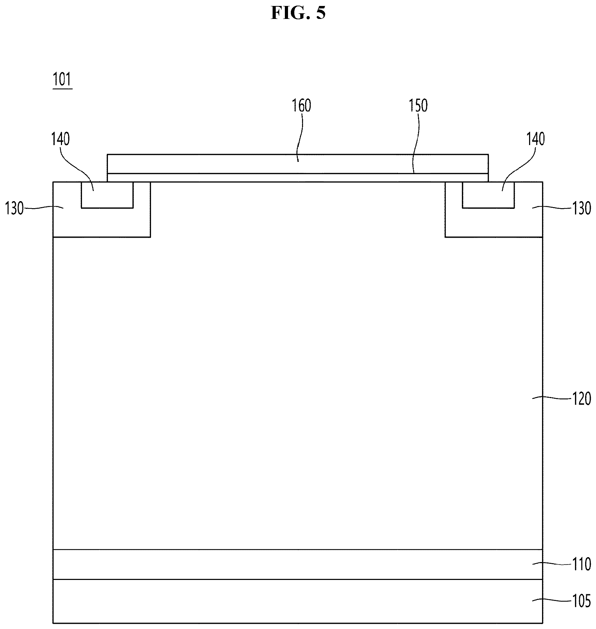

FIG. 5 is a cross-sectional view illustrating a power second power semiconductor device according to some embodiments.

A power semiconductor device 101 shown in FIG. 5 can be the first power semiconductor device 240 or the second power semiconductor device 250 shown in FIG. 3.

Referring to FIG. 5, the power semiconductor device 101 may comprise a substrate 110, a first conductivity type epitaxial layer 120, a second conductivity type well 130, a first conductivity type source region 140, a gate insulating layer 150, a gate electrode 160, and a drain electrode 105. The first conductivity type can be N-type, and the second conductivity type can be P-type, but they are not limited thereto.

For example, the power semiconductor device 101 can comprise the first conductive epitaxial layer 120 formed on the substrate 110 and the second conductive well 130 formed on the first conductive epitaxial layer 120, the first conductivity type source region 140 formed in the second conductivity type well 130, the gate insulating layer 150 and the gate electrode 160 formed on the first conductivity type source region 140, and the drain electrode 105 disposed under the substrate 110.

The substrate 110 and the first conductive epitaxial layer 120 can comprise a semiconductor compound such as SiC, GaN, or Ga₂O₃.

Referring back to FIG. 2 and FIG. 3, the first substrate 210 is disposed under the first power semiconductor device 240, and the second substrate 220 is disposed on the second power semiconductor device 250. The support 230 can be disposed between the first power semiconductor device 240 and the second power semiconductor device 250.

The first substrate 210 and the second substrate 220 can be heat dissipation substrates having excellent heat dissipation characteristics. The first substrate 210 and the second substrate 220 can be electrode substrates having excellent electrical conductivity.

The first power semiconductor device 240 can be electrically connected to the first substrate 210. Heat generated in the first power semiconductor device 240 can be emitted to the outside through the first substrate 210. The second power semiconductor device 250 can be electrically connected to the second substrate 220. Heat generated in the second power semiconductor device 250 can be emitted to the outside through the second substrate 220.

The support 230 can stably support the second power semiconductor device 250. The support 230 can be called a supporter, a seating part, a clip, or the like.

The support 230 can be a conductive support or a conductive member. That is, the support 230 can be made of metal. The support 230 can have a plate shape. The size of the support 230 can be greater than the size of the first power semiconductor device 240 or the second power semiconductor 250. In this case, the first power semiconductor device 240 can be disposed under the conductive support 230 so that an upper surface of the first power semiconductor device 240 can be connected to the conductive support 230 in surface contact. In addition, the second power semiconductor device 250 can be disposed on the conductive support 230 so that a lower surface of the second power semiconductor device 250 can be connected to the conductive support 230 in surface contact. In this way, since the first power semiconductor device 240 and/or the second power semiconductor device 250 are connected in surface contact with the plate-shaped conductive support 230, contact resistance between the first power semiconductor device 240 and/or the second power semiconductor device 250 and the conductive support 230 is minimized, thereby minimizing current loss. Accordingly, switching loss of the first power semiconductor device 240 or the second power semiconductor device 250 does not occur, enabling a high-power output and high-precision switching control.

The support 230 can comprise a first part 231, a second part 232, and a connection part 233. The second part 232 can be positioned higher than the first part 231. A second power semiconductor device 250 can be disposed on the second part 232. The second part 232 is located at the center and the first part 231 can be located on at least one side of the second part 232. The connection part 233 can connect the first part 231 and the second part 232. The first part 231, the second part 232, and the connection region 233 can be integrally formed, but are not limited thereto.

In the figures, the connection part 233 has an inclined shape, but it can have a shape perpendicular to the ground or have another shape.

The support 230 can have a recess 235. The recess 235 can be formed by the first part 231, the connection part 233 and the second part 232. The recess 235 can be formed under the support 230. This can be due to the fact that the second part 232 is positioned higher than the first part 231. That is, the recess 235 is formed by the step between the first part 231 and the second part 232 and the connection region 233 connecting the first part 231 and the second part 232. The first power semiconductor device 240 can be accommodated in the recess 235.

As shown in FIG. 2, the size of the support 230 can be greater than the size of the first power semiconductor device 240 or the second power semiconductor device 250.

The first part 231 can be fixed to the first substrate 210 in order to enhance the stability of the support 230. The support 230 can be electrically connected to the first substrate 210. For example, the first part 231 of the support 230 can be electrically connected to the first substrate 210.

The support 230 can be one of the first node N1, the second node N2, and the third node N3 shown in FIG. 1. Accordingly, when the first power semiconductor device 240 or the second power semiconductor device 250 is turned on, power at the input side can be output to the load 1200. Accordingly, the support 230 can be an output terminal.

In some embodiments, the power semiconductor module 201 can comprise a spacer 260.

The spacer 260 can be disposed between the first power semiconductor device 240 and the support 230. The spacer 260 can be disposed on the first power semiconductor device 240. The spacer 260 can be made of a metal having excellent electrical conductivity. Accordingly, the first power semiconductor device 240 can be electrically connected to the support 230 through the spacer 260.

A portion of an upper side of the first power semiconductor device 240, that is, a gate electrode, and the first substrate 210 can be electrically connected using a wire 290. In this case, a space between the first power semiconductor device 240 and the support 230 can be secured to prevent an electrical short between the wire 290 and the support 230. To this end, the spacer 260 can be disposed between the first power semiconductor device 240 and the support 230.

For example, the thickness of the spacer 260 can be secured so that an upper surface of the spacer 260 is higher than the uppermost side of the wire 290.

Since the wire 290 is connected on the portion of the upper side of the first power semiconductor device 240, the uppermost side of the wire 290 can be higher than the upper side of the first power semiconductor device 240. When there is no spacer 260, the wire 290 and the support 230 can be electrically shorted. Accordingly, the spacer 260 having a sufficiently thick thickness so that the upper surface of the spacer 260 is higher than the uppermost side of the wire 290 can be disposed on the first power semiconductor device 240 such that an electrical short between the wire 290 and the support 230 can be prevented.

As shown in FIG. 2 and FIG. 3, the size of the second part 232 of the support 230 can be greater than the size of the spacer 260. The size of the second part 232 of the support 230 can be greater than the size of the second power semiconductor device 250.

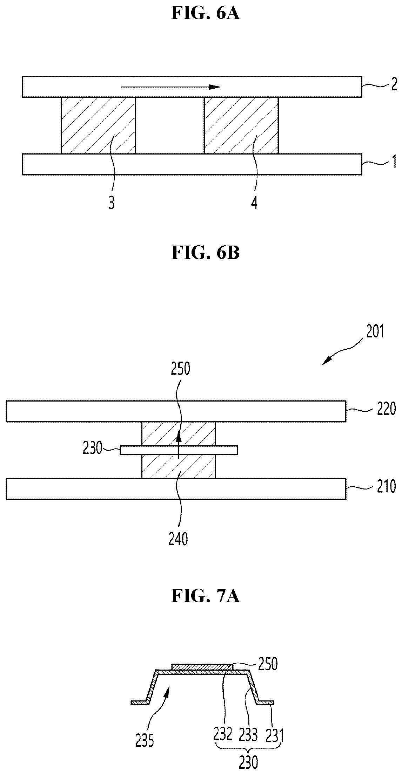

FIG. 6A shows a current path of a power semiconductor module and FIG. 6B shows a current path of a power semiconductor module according to some embodiments.

As shown in FIG. 6A, the power semiconductor module shown in FIG. 6A comprises a first power semiconductor device 3 and a second power semiconductor device 4 between a first substrate 1 and a second substrate 2. The first power semiconductor device 3 and the second power semiconductor device 4 are connected in series through the second substrate 2. In this case, the current path is formed through the first signal pattern (not shown) of the first substrate 1, the first power semiconductor device 3, the second substrate 2, the second power semiconductor device 4, and the second signal pattern (not shown) of the first substrate 1. Although not shown, the first power semiconductor device 3 and the second power semiconductor device 4 can be connected in series through the first substrate 1. In this case, the current path is formed through the first signal pattern (not shown) of the second substrate 2, the first power semiconductor device 3, the first substrate 1, the second power semiconductor device 4, and the second signal pattern (not shown) of the second substrate 2.

The first power semiconductor device 3 and the second power semiconductor device 4 are spaced apart at regular intervals to prevent an electrical short between the first substrate 1 and the second substrate 2. Therefore, as the separation gap (or interval) between the first power semiconductor device 3 and the second power semiconductor device 4 increases, the current path between the first power semiconductor device 3 and the second power semiconductor device 4 (see arrow) is increased. When the first power semiconductor device 3 or the second power semiconductor device 4 is turned off, stray inductance increases due to an increase in the current path. High-power output is difficult due to the increase in the stray inductance. In addition, when the overshooting voltage due to the increase in the stray inductance exceeds the withstand voltage of the first power semiconductor device 3 or the second power semiconductor device 4, there is a problem in that the first power semiconductor device 3 or the second power semiconductor device 4 is damaged or a switching loss of the first power semiconductor device 3 or the second power semiconductor device 4 occurs.

However, as shown in FIG. 6B, in the power semiconductor module 201, the first power semiconductor device 240 and the second power semiconductor device 250 can be connected in series via the support 230 between the first substrate 210 and the second substrate 220. In this case, the current path is formed through the first substrate 210 (or its first signal pattern), the first power semiconductor device 240, the support 230, the second power semiconductor device 250, and the second substrate (or its second signal pattern).

At this time, since the space between the first power semiconductor device 240 and the second power semiconductor device 250 is spaced only by the thickness of the support 230, the separation gap between the first power semiconductor device 240 and the second power semiconductor device 250 can be minimized. Accordingly, since the current path between the first power semiconductor device 240 and the second power semiconductor device 250 is minimized, when the first power semiconductor device 240 or the second power semiconductor device 250 is turned off, the stray inductance can be minimized or not generated. Therefore, since the overshooting voltage is not generated or minimized and the overshooting voltage does not exceed the withstand voltage of the first power semiconductor device 240 or the second power semiconductor device 250, the first power semiconductor device 240 or the second power semiconductor device 250 can not be damaged. In addition, since switching loss of the first power semiconductor device 240 or the second power semiconductor device 250 does not occur, a preset high-power output is possible.

In addition, in the power semiconductor module 201, the first power semiconductor device 240 and the second power semiconductor device 250 can be vertically overlapped with the support therebetween, and the first power semiconductor device 240 so that the placement area of the first power semiconductor device 240 and the second power semiconductor device 250 can be minimized. Thus, the size of the power semiconductor module 201 or the power semiconductor device can be minimized. Accordingly, more first power semiconductor devices 240 or second power semiconductor devices 250 can be mounted per unit area in the power semiconductor module 201 or the power semiconductor device, enabling higher power output.

The power semiconductor module 201 can comprise a plurality of first terminals 270 and a plurality of second terminals 280. The first terminal 270 can be an input terminal, and the second terminal 280 can be an output terminal. Instead of a terminal, it can also be called a terminal, pin, lead frame, etc.

The plurality of first terminals 270 can be electrically connected to the first substrate 210 and/or the second substrate 220. The plurality of second terminals 280 can be electrically connected to the first substrate 210 and/or the second substrate 220.

The plurality of first terminals 270 can be members for receiving a gate signal, a high potential voltage, a low potential voltage, a ground voltage, and other various signals. The plurality of second terminals 280 can be members for outputting output voltage, ground voltage, and other various signals.

In the drawing, the plurality of first terminals 270 are provided with four and the plurality of second terminals 280 are provided with four, but more than these can be provided.

The power semiconductor module 201 can comprise a mold 295.

The mold 295 can be disposed between the first substrate 210 and the second substrate 220. The mold 295 can surround an outer surface of the first power semiconductor device 240 between the first substrate 210 and the second substrate 220. The mold 295 can surround each of the plurality of first terminals 270 and each of the plurality of second terminals 280 between the first substrate 210 and the second substrate 220.

The mold 295 can be disposed outside the first substrate 210 and outside the second substrate 220. The mold 295 can surround each of the plurality of first terminals 270 on the outside of the first substrate 210. The mold 295 can surround each of the plurality of second terminals 280 on the outside of the second substrate 220.

The mold 295 is a semiconductor encapsulant and can be a material that encapsulates a power second semiconductor device such as a silicon chip, a gold wire 290, or a lead frame to protect it from heat, moisture, impact, or the like. For example, an epoxy molding compound (EMC) can be used as the mold 295. EMC is a composite material that uses about 10 raw materials such as silica, epoxy resin, phenol resin, carbon black, and flame retardant. EMC can be used as an encapsulant for the first power semiconductor device 240, the second power semiconductor device 250, the plurality of first terminals 270, and the plurality of second terminals 280.

The mold 295 can be formed between the first substrate 210 and the second substrate 220, on the outside of the first substrate 210, on the outside of the second substrate 220, etc., by using an EMC compounding process.

The first power semiconductor device 240 can be adhered to the first substrate 210 and the support 230 using an adhesive member (not shown). For example, the first power semiconductor device 240 can be adhered to the first substrate 210 and the support 230 using an adhesion process such as soldering, sintering, or eutectic bonding. The second power semiconductor device 250 can be adhered to the second substrate 220 and the support 230 using an adhesive member. For example, the second power semiconductor device 250 can be adhered to the second substrate 220 and the support 230 using an adhesion process such as soldering, sintering, or eutectic bonding.

The adhesive member can be made of a metal or metal alloy having excellent electrical conductivity and/or adhesive performance, but is not limited thereto. During the soldering process, Pb or the like can be used as an adhesive member. During the sintering process, Fe-Cu-C-based materials and additives such as Ni, Mo, MnS, Pb, etc. can be used as the adhesive member. During the eutectic bonding process, Sn-Pb, Cu-Sn, Au-Sn, Au-Si, etc. can be used as an adhesive member.

Accordingly, the first power semiconductor device 240 can be physically fixed and electrically connected to the first substrate 210 and the support 230 by the adhesive member. In addition, the second power semiconductor device 250 can be physically fixed and electrically connected to the second substrate 220 and the support 230 by the adhesive member.

FIG. 4 is a detailed cross-sectional view illustrating the power semiconductor module.

Referring to FIG. 4, the first power semiconductor device 240 can comprise a first gate electrode 241, a first source electrode 242, and a first drain electrode 243 on its outside. When the first power semiconductor device 240 is turned on in response to a gate signal applied to the first gate electrode 241, current can flow from the first drain electrode 243 to the first source electrode 242.

The first drain electrode 243 can be disposed on the lower side, and the first gate electrode 241 and the first source electrode 242 can be disposed on the upper side. In this case, the first drain electrode 243 can be physically fixed and electrically connected to the upper side of the first substrate 210 through surface contact. The first source electrode 242 can be physically fixed and electrically connected to the lower side of the spacer 260 through surface contact. The first gate electrode 241 can be electrically connected to the first substrate 210 through a wire 290.

The second power semiconductor device 250 can comprise a second gate electrode 251, a second source electrode 252, and a second drain electrode 253 on its outside. When the second power semiconductor device 250 is turned on in response to a gate signal applied to the second gate electrode 251, current can flow from the second drain electrode 253 to the first source electrode 242.

The second drain electrode 253 can be disposed on a lower side, and the second gate electrode 251 and the second source electrode 252 can be disposed on an upper side. In this case, the second drain electrode 253 can be physically fixed and electrically connected to the upper side of the support 230 in surface contact. The second source electrode 252 can be physically and electrically connected to the lower side of the second substrate 220 in surface contact. The second gate electrode 251 can be physically and electrically connected to the lower side of the second substrate 220 in surface contact.

Structures of the first power semiconductor device 240 and the second power semiconductor device 250 can be the same as those of the power semiconductor devices shown in FIG. 5, but are not limited thereto.

The first substrate 210 can comprise a plurality of layers. For example, the first substrate 210 can comprise a first metal layer 211, a first insulating layer 212 and a second metal layer 213.

The first metal layer 211 can be made of a material having excellent electrical conductivity. The first metal layer 211 can comprise a plurality of first signal patterns 211a to 211e. The plurality of first signal patterns 211a to 211e can be electrically connected to the plurality of first terminals 270, the first power semiconductor device 240, the support 230, and the plurality of second terminals 280.

For example, each of the plurality of first-first signal patterns 211a can be physically fixed to and electrically connected to the plurality of first terminals 270 using an adhesive member. For example, each of the plurality of first-second signal patterns 211b can be physically fixed to and electrically connected to the plurality of second terminals 280 using an adhesive member. For example, the first-third signal patterns 211c can be physically fixed to and electrically connected to the first part 231 of the support 230 using an adhesive member. The first-third signal patterns 211c are electrically connected to one of the plurality of second terminals 280 so that a positive polarity voltage or a negative polarity voltage can be supplied to the outside according to the turnon of the first power semiconductor device 240 or the second power semiconductor device 250.

For example, the first-fourth signal patterns 211d can be physically fixed and electrically connected to the first drain electrode 243 of the first power semiconductor device 240 by using an adhesive member. The first-fourth signal patterns 211d can be electrically connected to one of the plurality of first terminals 270 to receive a high potential voltage (or positive polarity voltage) from the outside. For example, the first-fifth signal patterns 211e can be electrically connected to the first gate electrode 241 of the first power semiconductor device 240 through the wire 290. The first-fifth signal patterns 211e can be electrically connected to one of the plurality of first terminals 270 to receive a gate signal from the outside.

The first insulating layer 212 can electrically insulate the first metal layer 211 and the second metal layer 213. The first insulating layer 212 can be made of a ceramic material having high thermal conductivity, such as Al₂O₃.

The second metal layer 213 can be made of a material having excellent heat dissipation characteristics. One side of the second metal layer 213 can be in contact with the first insulating layer 212 and heat can be emitted to the other side of the second metal layer 213. Although not shown, a heat dissipation means including a cooling medium can be disposed on the other side of the second metal layer 213.

The second substrate 220 can comprise a plurality of layers. For example, the second substrate 220 can comprise a third metal layer 221, a second insulating layer 222 and a fourth metal layer 223.

The third metal layer 221 can be made of a material having excellent electrical conductivity. The third metal layer 221 can comprise a plurality of second signal patterns 221a to 221d. The plurality of second signal patterns 221a to 221d can be electrically connected to the plurality of first terminals 270, the second power semiconductor device 250, and the plurality of second terminals 280.

For example, the plurality of second-first signal patterns 221a are input signal patterns, and can be physically fixed and electrically connected to the plurality of first terminals 270 using an adhesive member. For example, the plurality of second-second signal patterns 221b are output signal patterns, and can be physically fixed and electrically connected to the plurality of second terminals 280 using an adhesive member. For example, the second-third signal pattern 221c can be physically fixed and electrically connected to the second gate electrode 251 of the second power semiconductor device 250 using an adhesive member. The second-third signal pattern 221c is electrically connected to one of the plurality of second terminals 280 to receive a gate signal from the outside. For example, the second-fourth signal pattern 221d can be physically fixed and electrically connected to the second source electrode 252 of the second power semiconductor device 250 using an adhesive member. For example, the second-fourth signal pattern 221d can be electrically connected to one of the plurality of second terminals 280 to receive a low potential voltage (or negative polarity voltage) from the outside.

The second insulating layer 222 can electrically insulate the third metal layer 221 and the fourth metal layer 223 from each other. The second insulating layer 222 can be made of a ceramic material having high thermal conductivity, for example, Al₂O₃.

The fourth metal layer 223 can be made of a material having excellent heat dissipation characteristics. One side of the fourth metal layer 223 can be in contact with the second insulating layer 222 and heat can be emitted to the other side. Although not shown, a heat dissipation means including a cooling medium can be disposed on the other side of the fourth metal layer 223.

Referring back to FIG. 4, each of the plurality of first terminals 270 can comprise a first-first terminal 271, a first insulating layer 272, and a first-second terminal 273.

The first insulating layer 272 can electrically insulate the first-first terminal 271 and the first-second terminal 273 from each other. The first-first terminal 271 can be physically fixed to and electrically connected to the first-first signal pattern 211a of the first substrate 210. The first-second terminal 273 can be physically fixed to and electrically connected to the second-first signal pattern 221a of the second substrate 220.

Each of the plurality of second terminals 280 can comprise a second-first terminal 281, a second insulating layer 282, and a second-second terminal 283.

The second insulating layer 282 can electrically insulate the second-first terminal 281 and the second-second terminal 283 from each other. The second-first terminal 281 can be physically fixed to and electrically connected to the first-second signal pattern 211b of the first substrate 210. The second-second terminal 283 can be physically fixed to and electrically connected to the second-second signal pattern 221b of the second substrate 220.

As described above, the first power semiconductor device 240 and the second power semiconductor device 250 can be vertically overlapped. In this case, the first power semiconductor device 240 and the second power semiconductor device 250 can be connected in series with the support 230 and the spacer 260 interposed therebetween. That is, the spacer 260 and the support 230 are electrically connected to each other, the first source electrode 242 of the first power semiconductor device 240 is electrically connected to the spacer 260, and the second drain electrode 253 of the second power semiconductor device 250 is electrically connected to the support 230 such that the first power semiconductor device 240 and the second power semiconductor device 250 can be connected in series.

In FIG. 6A, when the first power semiconductor device 3 and the second power semiconductor device 4 are horizontally connected in series through the second substrate 2, the current path between the first power semiconductor device 3 and the second power semiconductor device 4 is increased due to the separation gap between the first power semiconductor device 3 and the second power semiconductor device 4, thereby increasing stray inductance. Due to the increase in the stray inductance, the first power semiconductor device 3 or the fourth power semiconductor device 4 is damaged. In addition, switching loss of the first power semiconductor device 3 or the fourth power semiconductor device 4 increases due to the increase in the stray inductance, and it is difficult to obtain a preset high-power output due to such switching loss. In addition, since the first substrate 1 and the second substrate 2 are spaced apart from each other in the horizontal direction, the size is increased, and a larger size is required to increase high-power output.

However, as shown in FIG. 6B, in the power semiconductor module 201 according to some embodiments, the first power semiconductor device 240 and the second power semiconductor device 250 can be vertically connected in series through the support 230, the current path is drastically reduced so that stray inductance does not occur or can be minimized. Accordingly, damage to the first power semiconductor device 240 or the second power semiconductor device 250 is prevented, and no switching loss is generated so that a preset high-power output is possible. In addition, by arranging the first power semiconductor device 240 and the second power semiconductor device 250 in the vertical direction, the size is reduced so that the output characteristics per unit area can be improved. In addition, the size and the weight of product are drastically reduced, thereby improving the fuel efficiency of the vehicle including the power semiconductor module 201.

FIG. 7A to FIG. 7E illustrate a manufacturing process of a power semiconductor module according to some embodiments.

As shown in FIG. 7A, a support 230 can be provided. The support 230 can be made of metal.

The support 230 can comprise a first part 231, a second part 232, and a connection part 233. The second part 232 can be positioned higher than the first part 231. The connection part 233 can connect the first part 231 and the second part 232. A recess 235 can be formed by the first part 231, the connection region 233, and the second part 232. the recess 235 can be formed under the second part 232. The first part 231, the connection region 233, and the second part 232 can be integrally formed, but are not limited thereto.

The second power semiconductor device 250 can be formed on the support 230. The second power semiconductor device 250 can be formed on the second part 232 of the support 230. The second power semiconductor device 250 can be adhered to the support 230 using an adhesive member. For example, after the adhesive member is formed on the lower side of the second power semiconductor device 250 or on the upper side of the second part 232 of the support 230, the second power semiconductor device 250 can be adhered to the support 230 through an adhesive process.

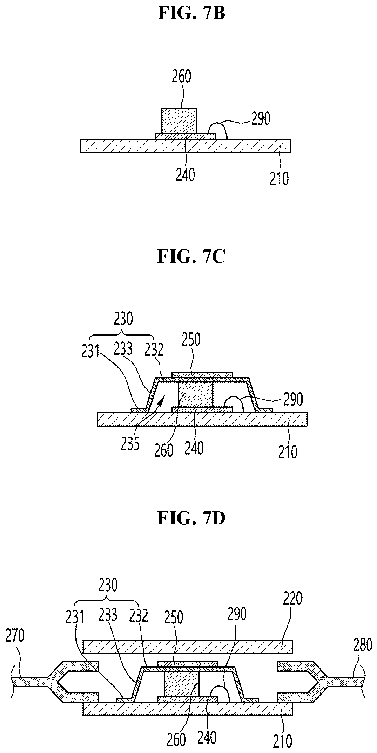

As shown in FIG. 7B, a first substrate 210 can be provided. The first substrate 210 can be made of a material having excellent electrical conductivity and/or heat dissipation characteristics.

A first power semiconductor device 240 can be formed on the first substrate 210. The first power semiconductor device 240 can be adhered to the first substrate 210 using an adhesive member. The first power semiconductor device 240 can be electrically connected to the first substrate 210 through the adhesive member.

A spacer 260 can be formed on the first power semiconductor device 240. The spacer 260 can be adhered to the first power semiconductor device 240 using an adhesive member. The spacer 260 can be electrically connected to the first power semiconductor device 240 through the adhesive member.

The first power semiconductor device 240 can be electrically connected to the first substrate 210 through a wire 290.

Referring to FIG. 4, the first power semiconductor device 240 can have a first drain electrode 243 disposed on a lower side thereof and a first source electrode 242 and a first gate electrode 241 disposed on an upper side thereof.

The first drain electrode 243 of the first power semiconductor device 240 can be electrically connected to the first-fourth signal patterns 211d of the first substrate 210 through an adhesive member, and the first source electrode 242 of the first power semiconductor device 240 can be electrically connected to the spacer 260 through an adhesive member, and the first gate electrode 241 of the first power semiconductor device 240 can be electrically connected to the first-fifth signal patterns 211e of the first substrate 210 through a wire 290.

As shown in FIG. 7C, one side of the support 230 can be fixed to the first substrate 210. The first part 231 of the support 230 can be adhered to the first substrate 210 through an adhesive member. Referring to FIG. 4, the first part 231 of the support 230 can be electrically connected to the first-third signal patterns 211c of the first substrate 210 through an adhesive member.

The second part 232 of the support 230 is positioned higher than the uppermost side of the wire 290 so that an electrical short between the wire 290 and the support 230 can be prevented by making the recess 235 sufficiently large.

The spacer 260 can maintain the second part 232 of the support 230 at a constant height without sagging downward. Therefore, the spacer 260 prevents the second part 232 of the support 230 from sagging downward while maintaining a constant height, thereby preventing an electrical short between the support 230 and the wire 290. In addition, the spacer 260 can serve as a medium for electrical connection between the first power semiconductor device 240 and the support 230.

As shown in FIG. 7D, after locating the plurality of first terminals 270 and the plurality of second terminals 280 on both sides of the first substrate 210, the second substrate 220 can be placed on the first substrate 210, the plurality of second terminals 270, and the plurality of second terminals 280.

Thereafter, by pressurizing and applying heat to the first substrate 210 and/or the second substrate 220, the plurality of first terminals 270 and the plurality of second terminals 280 can be adhered to the first substrate 210, and the plurality of first terminals 270, the plurality of second terminals 280, and the second power semiconductor device 250 can be adhered to the second substrate 220. An adhesive member can be previously formed on the lower side of the second substrate 220 or on the upper side of each of the plurality of first terminals 270, the plurality of second terminals 280, and the second power semiconductor device 250. Accordingly, the plurality of first terminals 270 and the plurality of second terminals 280 can be adhered to the first substrate 210 through the adhesive member, and the plurality of first terminals 270 and the plurality of second terminals 280 and the second power semiconductor device 250 can be adhered to the second substrate 220.

Referring to FIG. 4, the plurality of first-first terminals 271 can be physically fixed and electrically connected to the plurality of first-first signal patterns 211a of the first substrate 210 through an adhesive member. The plurality of first-second terminals 273 can be physically fixed and electrically connected to the plurality of second-first signal patterns 221a of the second substrate 220 through an adhesive member. The plurality of second-first terminals 281 can be physically fixed and electrically connected to the plurality of first-second signal patterns 211b of the first substrate 210 through an adhesive member. The plurality of second-second terminals 283 can be physically fixed and electrically connected to the plurality of second-second signal patterns 221b of the second substrate 220 through an adhesive member. A second gate electrode 251 and a second source electrode 252 can be disposed on the upper side of the second power semiconductor device 250. The second source electrode 252 of the second power semiconductor device 250 can be physically fixed and electrically connected to the second-third signal pattern 221c of the second substrate 220 through an adhesive member. The second gate electrode 251 of the second power semiconductor device 250 can be physically fixed and electrically connected to the second-fourth signal patterns 221d of the second substrate 220 through an adhesive member.

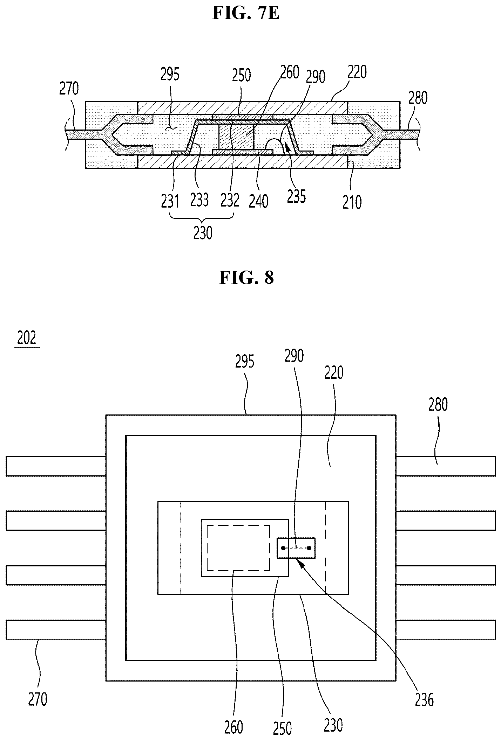

As shown in FIG. 7E, the mold 295 is formed between the first substrate 210 and the second substrate 220, the outside of the first substrate 210, and the outside of the second substrate 220 using an EMC compounding process. Accordingly, the power semiconductor module (201 in FIGS. 2 and 3) can be manufactured.

FIG. 8 is a plan view illustrating a power semiconductor module according to some embodiments.

The embodiments shown in FIG. 8 are same as the embodiments shown in FIG. 2 except for the opening 236. In FIG. 8, the same reference numerals are assigned to components having the same shape, structure and/or function as those in FIG. 2, and detailed descriptions are omitted.

Referring to FIG. 4 and FIG. 8, the power semiconductor module 202 can comprise a first substrate 210, a second substrate 220, a support 230, a first power semiconductor device 240, and a second power semiconductor device 250. The power semiconductor module 202 can comprise a spacer 260, a plurality of first terminals 270, a plurality of second terminals 280, and a mold 295.

The support 230 can comprise a first part 231, a second part 232, and a connection part 233. The connection part 233 can connect the first part 231 and the second part 232. The first part 231, the connection region 233, and the second part 232 can be integrally formed, but are not limited thereto. The second part 232 can be positioned higher than the first part 231. A recess 235 can be formed by the first part 231, the connection region 233, and the second part 232. The recess 235 can be formed under the second part 232.

In this case, the first power semiconductor device 240 can be disposed in the recess 235 and the second power semiconductor device 250 can be disposed on the second part 232. The first power semiconductor device 240 and the second power semiconductor device 250 can be vertically overlapped with the second part 232 of the support 230 interposed therebetween.

In addition, the spacer 260 can be formed in the recess 235. The spacer 260 can be disposed on the first power semiconductor device 240.

In the first power semiconductor device 240, the first drain electrode 243 can be disposed on the lower side thereof, and the first gate electrode 241 and the first source electrode 242 can be disposed on the upper side thereof. In this case, the first drain electrode 243 can be electrically connected to the first-fourth signal patterns 211d of the first substrate 210, the first gate electrode 241 can be electrically connected to the first-fifth signal patterns 211e of the first substrate 210 through a wire 290, and the first source electrode 242 can be electrically connected to the spacer 260.

When a gate signal is supplied to the first gate electrode 241 of the first power semiconductor device 240 through the wire 290 and the first power semiconductor device 240 is turned on, a high potential voltage (or positive polarity voltage) can be supplied to the support 230 via the first power semiconductor device 240 and the spacer 260. Therefore, since different voltages are supplied to the wire 290 and the support 230, they must not be electrically shorted. However, since the wire 290 can be bent in a curved shape or moved to a higher position, an electrical short can occur between the wire 290 and the support 230.

To overcome this problem, an opening 236 can be formed in the support 230 in the power semiconductor module 202. For example, the opening 236 can be formed to correspond to the wire 290. For example, the opening 236 can be formed in the second part 232 of the support 230. For example, the opening 236 can be formed in the connection part 233 of the support 230. For example, the opening 236 can be formed in the first part 231 of the support 230.

Accordingly, even if the wire 290 is deformed, the wire 290 can be located in the opening 236 of the support 230 such that an electrical short between the support 230 and the wire 290 can be prevented.

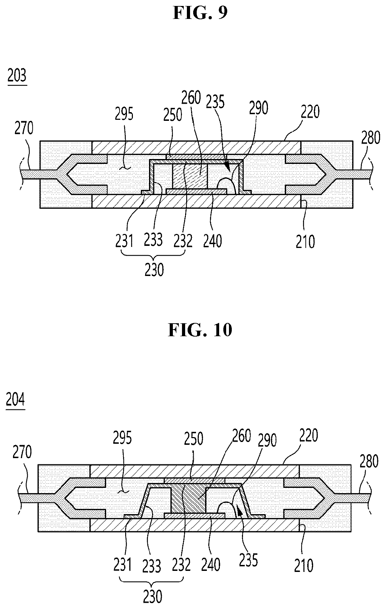

FIG. 9 is a cross-sectional view illustrating a power semiconductor module.

Embodiments shown in FIG. 9 are same as the embodiments shown in FIG. 3 and/or 4 except for the shape of the support 230. In embodiments shown in FIG. 9, the same reference numerals are given to components having the same shape, structure and/or function as those in the previously discussed embodiments, and detailed descriptions are omitted.

Referring to FIG. 9, a power semiconductor module 203 can comprise a first substrate 210, a second substrate 220, a support 230, a first power semiconductor device 240, and a second power semiconductor device 250. The power semiconductor module 203 can comprise a spacer 260, a plurality of first terminals 270, a plurality of second terminals 280, and a mold 295.

The support 230 can comprise a first part 231, a second part 232, and a connection part 233. The connection part 233 can connect the first part 231 and the second part 232. The first part 231, the connection region 233, and the second part 232 can be integrally formed, but are not limited thereto. The second part 232 can be positioned higher than the first part 231.

The connection part 233 can have a shape perpendicular to the ground. In the embodiments shown in FIG. 3 and/or 4, the connection part 233 has an inclined shape with respect to the ground, whereas in the embodiments shown in FIG. 9, the connection part 233 can have a shape perpendicular to the ground.

According to the embodiments shown in FIG. 9, since the connection part 233 has a shape perpendicular to the ground so that the connection part 233 is spaced farther from the wire 290, the possibility of an electrical short between the support 230 and the wire 290 can be further reduced.

According to the embodiments shown in FIG. 9, since the connection part 233 has a shape perpendicular to the ground, the rigidity of the support 230 can be further increased. Accordingly, the stability of the support 230 can be enhanced, and left-right displacement of the support 230 can be suppressed such that the possibility of an electrical short between the support 230 and the wire 290 can be further reduced. In addition, as the support strength of the support 230 increases, the second power semiconductor device 250 can be stably supported.

FIG. 10 is a cross-sectional view illustrating a power semiconductor module according to some embodiments.

The embodiments shown in FIG. 10 is the same as the embodiments shown in FIGS. 3, 4, and/or 9 except that the support 230 and the spacer 260 are integrally formed. In the embodiments shown in FIG. 10, the same reference numerals are assigned to components having the same shape, structure and/or function as those in the embodiments shown in FIGS. 3, 4, and/or 9, and detailed descriptions are omitted.

Referring to FIG. 10, a power semiconductor module 204 can comprise a first substrate 210, a second substrate 220, a support 230, a first power semiconductor device 240, and a second power semiconductor device 250. The power semiconductor module 204 can comprise a spacer 260, a plurality of first terminals 270, a plurality of second terminals 280, and a mold 295.

The support 230 can comprise a first part 231, a second part 232, and a connection part 233. The connection part 233 can connect the first part 231 and the second part 232. The first part 231, the connection region 233, and the second part 232 can be integrally formed, but are not limited thereto. The second part 232 can be positioned higher than the first part 231. A recess 235 can be formed by the first part 231, the connection region 233, and the second part 232. The recess 235 can be formed under the second part 232.

In this case, the first power semiconductor device 240 can be disposed in the recess 235 and the second power semiconductor device 250 can be disposed on the second part 232. The first power semiconductor device 240 and the second power semiconductor device 250 can be vertically overlapped with the second part 232 of the support 230 interposed therebetween.

In addition, the spacer 260 can be formed in the recess 235. The spacer 260 can be disposed on the first power semiconductor device 240.

In the power semiconductor module 204 shown in FIG. 10, the support 230 and the spacer 260 can be integrally formed. That is, the spacer 260 can protrude from the support 230 toward the first power semiconductor device 240.

As an example, the support 230 can be etched using an etching process to form an unetched area as the spacer 260. As another example, the spacer 260 can be adhered to the lower side of the support 230 using an adhesive process. As another example, a plurality of metal layers can be formed under the support 230 by using a plurality of deposition processes, and the plurality of metal layers can be formed as the spacer 260. In addition to this, the support 230 and the spacer 260 can be integrally formed through various processes.

In the embodiments shown in FIG. 10, there is no need for a process of adhering to the spacer 260 and the support 230 using an adhesive member so that the process can be simplified.

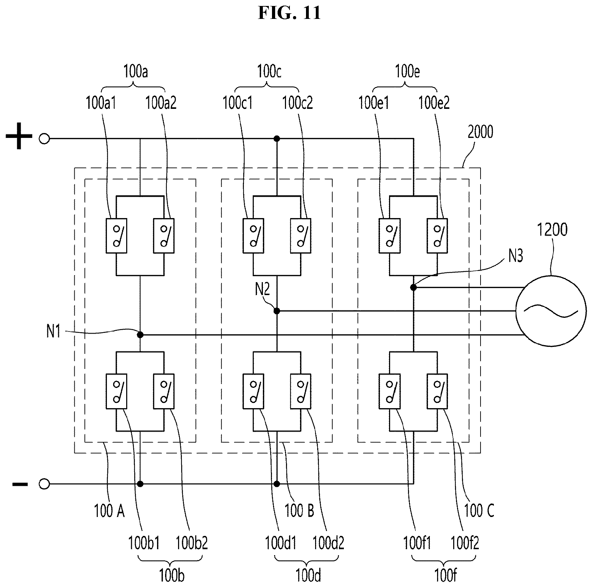

FIG. 11 is a circuit diagram illustrating an automotive inverter according to some embodiments.

The embodiments shown in FIG. 11 are same as the embodiments shown in FIG. 1 except that a plurality of power semiconductor devices 100a1, 100a2, 100b1, 100b2, 100c1, 100c2, 100d1, 100d2, 100e1, 100e2, 100f1 and 100f2 are connected in parallel to each arm 100a to 100f.

Referring to FIG. 11, the automotive inverter 2000 can comprise a 3-phase inverter, but is not limited thereto. The automobile inverter 2000 can comprise a plurality of legs 100A, 100B, and 100C. For example, the first leg 100A, the second leg 100B, and the third leg 100C can be connected in parallel to the load 1200, that is, the motor, through the first node N1, the second node N2, and the third node N3, respectively. The first leg 100A can comprise a first arm 100a and a second arm 100b connected in series with each other, and the second leg 100B can comprise a third arm 100c and a fourth arm 100d connected in series with each other. Here, the first arm 100a, the third arm 100c, and the fifth arm 100e are called upper arms, and the second arm 100b, the fourth arm 100d, and the sixth arm 100f are called the lower arm.

The first arm 100a to the sixth arm 100a to 100f each have a plurality of power semiconductor devices 100a1, 100a2, 100b1, 100b2, 100c1, 100c2, 100d1, 100d2, 100e1, 100e2, 100f1 and 100f2 connected in parallel. Although not shown, in the first arm 100a to the sixth arm 100f, the plurality of power semiconductor devices 100a1, 100a2, 100b1, 100b2, 100c1, 100c2, 100d1, 100d2, 100e1, 100e2, 100f1, and 100f2 can be connected in parallel to diodes 100a-2, 100b-2, 100c-2, 100d-2, 100e-2, and 100f-2, respectively.

In the first arm 100a, the plurality of first power semiconductor devices 100a1 and 100a2 can be connected in parallel. In the second arm 100b, the plurality of second power semiconductor devices 100b1 and 100b2 can be connected in parallel. In the third arm 100c, the plurality of first power semiconductor devices 100c1 and 100c2 can be connected in parallel. In the fourth arm 100d, the plurality of second power semiconductor devices 100d1 and 100d2 can be connected in parallel. In the fifth arm 100e, the plurality of first power semiconductor devices 100e1 and 100e2 can be connected in parallel. In the sixth arm 100f, the plurality of second power semiconductor devices 100f1 and 100f2 can be connected in parallel.

In this case, one side of each of the plurality of first power semiconductor devices 100a1 and 100a2 of the first arm 100a, one side of each of the plurality of first power semiconductor devices 100c1 and 100c2 of the third arm 100c and one side of each of the plurality of first power semiconductor devices 100e1 and 100e2 of the fifth arm 100e can be connected in common. Here, one side can be a drain electrode.

The other side of each of the plurality of first power semiconductor devices 100a1 and 100a2 of the first arm 100a can be connected in common and be connected to the first node N1. The other side of each of the plurality of first power semiconductor devices 100c1 and 100c2 of the third arm 100c can be connected in common and connected to the second node N2. The other sides of each of the plurality of first power semiconductor devices 100e1 and 100e2 of the fifth arm 100e can be connected in common and connected to the third node N3. Here, the other side can be a source electrode.

One side of each of the plurality of second power semiconductor devices 100b1 and 100b2 of the second arm 100b can be connected in common and connected to the first node N1. One side of each of the plurality of second power semiconductor devices 100d1 and 100d2 of the fourth arm 100d can be connected in common and connected to the second node N2. One side of each of the plurality of second power semiconductor devices 100f1 and 100f2 of the sixth arm 100f can be connected in common and connected to the third node N3. Here, one side can be a drain electrode.

The other side of each of the plurality of second power semiconductor devices 100b1 and 100b2 of the second arm 100b, the other side of each of the plurality of second power semiconductor devices 100d1 and 100d2 of the fourth arm 100d and the other side of each of the plurality of second power semiconductor devices 100f1 and 100f2 of 100f of the sixth arm 100f can be connected in common. Here, one side can be a source electrode.

Each of the plurality of first power semiconductor devices 100a1 and 100a2 of the first arm 100a comprised in the first leg 100A and each of the plurality of second power semiconductor devices 100b1 and 100b2 of the second arm 100b can be connected in series. Each of the plurality of first power semiconductor devices 100c1 and 100c2 of the third arm 100c comprised in the second leg 100B and each of the plurality of second power semiconductor devices 100d1 and 100d2 of the fourth arm 100d can be connected in series. Each of the plurality of first power semiconductor devices 100e1 and 100e2 of the fifth arm 100e and each of the plurality of second power semiconductor devices 100f1 and 100f2 of the sixth arm 100f comprised in the third leg 100C can be connected in series.

As such, the plurality of power semiconductor devices 100a1, 100a2, 100b1, 100b2, 100c1, 100c2, 100d1, 100d2, 100e1, 100e2, 100f1 and 100f2 can be connected in parallel to each arm 100a to 100f so that current characteristics can be improved and higher power output can be achieved

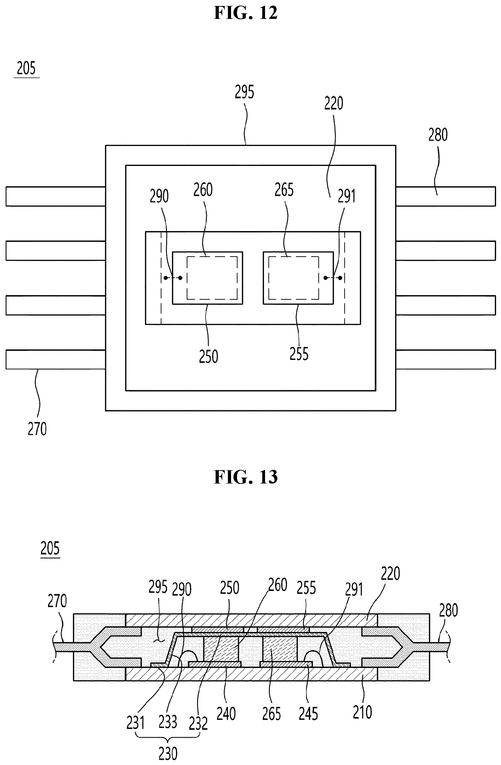

FIG. 12 is a plan view illustrating a power semiconductor module according some embodiments. FIG. 13 is a cross-sectional view illustrating a power semiconductor module according to some embodiments.

The power semiconductor module 205 shown in FIG. 13 can be one of the first leg 100A, the second leg 100B, and the third leg 100C shown in FIG. 11. Although not shown, the power semiconductor module 205 can be included in any one or more of the first leg 100A, the second leg 100B, and the third leg 100C.

The embodiments shown in FIG. 12 is the same as the above discussed embodiments except for the plurality of first power semiconductor devices 240 and 245 and the plurality of second power semiconductor devices 250 and 255. In FIG. 12, the same reference numerals are given to components having the same shape, structure and/or function as those in the above discussed embodiments, and detailed descriptions are omitted.

Referring to FIG. 12 and FIG. 13, the power semiconductor module 205 can comprise a first substrate 210, a second substrate 220, a support 230, a plurality of first power semiconductor devices 240 and 245, and a plurality of second power semiconductor devices 250 and 255. The power semiconductor module 205 can comprise a plurality of spacers 260 and 265, a plurality of first terminals 270, a plurality of second terminals 280, and a mold 295.

The first substrate 210, the second substrate 220, the support 230, the plurality of first terminals 270, and the plurality of second terminals 280 have already been described in the above discussed embodiments. Therefore, detailed descriptions are omitted.

The plurality of spacers 260 and 265 can be disposed between the first substrate 210 and the support 230. The plurality of spacers 260 and 265 can be disposed on the plurality of first power semiconductor devices 240 and 245, respectively. Although not shown, the plurality of spacers 260 and 265 can be integrally formed as a single spacer instead of being separated individually. Accordingly, the single spacer can be disposed not only on the plurality of first power semiconductor devices 240 and 245 but also in the space between the plurality of first power semiconductor devices 240 and 245.

The plurality of first power semiconductor devices 240 and 245 can be included in the first arm 100a of the first leg 100A, the third arm 100c of the second leg 100B and/or the fifth arm 100e of the leg 100C shown in FIG. 11. The plurality of first power semiconductor devices 240 and 245 can be connected in parallel. One side of each of the plurality of first power semiconductor devices 240 and 245 can be connected to the first substrate 210 in common, and the other side of each of the plurality of first power second semiconductor devices can be connected to the plurality of spacers 260 and 265. The plurality of spacers 260 and 265 can be commonly connected to the support 230. Here, said one side can be a first drain electrode 243, and said other side can be a first source electrode 242.

Another side of each of the plurality of first power semiconductor devices 240 and 245 can be connected to the first substrate 210 through a plurality of wires 290 and 291. For example, another side of each of the plurality of first power semiconductor devices 240 and 245 can be independently or commonly connected to the first substrate 210 through a plurality of wires 290 and 291. Here, said another side can be a first gate electrode 241,

The plurality of second power semiconductor devices 250 and 255 can be comprised in the second arm 100b of the first leg 100A, the fourth arm 100d of the second leg 100B and/or the sixth arm 100f of the third leg 100C shown in FIG. 11. One side of each of the plurality of second power semiconductor devices 250 and 255 can be commonly connected to the support 230, and the other side of each of the plurality of second power semiconductor devices 250 and 255 can be in common connected to the second substrate 220. Here, said one side can be a second drain electrode 253, and the said other side can be a second source electrode 252.

Another side of each of the plurality of second power semiconductor devices 250 and 255 can be connected to the second substrate 220. For example, another side of each of the plurality of second power semiconductor devices 250 and 255 can be independently or commonly connected to the second substrate 220. Here, an example of said another side can be a second gate electrode 251

Each of the plurality of first power semiconductor devices 240 and 245 and each of the plurality of second power semiconductor devices 250 and 255 can be vertically overlapped. For example, each of the plurality of first power semiconductor devices 240 and 245 and each of the plurality of second power semiconductor devices 250 and 255 can be vertically overlapped with the support 230 therebetween. The plurality of first power semiconductor devices 240 and 245 and the plurality of second power semiconductor devices 250 and 255 can be connected in series through the support 230.

Although not shown, the plurality of first power semiconductor devices 240 and 245 comprised in the first arm 100a, the third arm 100c, and the fifth arm 100e can be connected in series to increase withstand voltage characteristics, and the plurality of second power semiconductor devices 250 and 255 comprised in the second arm 100b, the fourth arm 100d, and the sixth arm 100f can be connected in series.

Although not shown, the plurality of first power semiconductor devices 240 and 245 can be connected in parallel in a horizontal direction or connected in series in a vertical direction. Alternatively, the plurality of first power semiconductor devices 240 and 245 can be connected in parallel in a horizontal direction or connected in series in a vertical direction.

The plurality of second power semiconductor devices 250 and 255 can be connected in parallel in a horizontal direction or connected in series in a vertical direction. Alternatively, the plurality of second power semiconductor devices 250 and 255 can be connected in parallel in a horizontal direction or connected in series in a vertical direction.

According to the embodiments shown FIG. 12, the plurality of first power semiconductor devices 240 and 245 can be connected in parallel, and the plurality of second power semiconductor devices 250 and 255 can be connected in parallel so that current characteristics can be improved and high-power output can be achieved.

The above detailed description should not be construed as limiting in all respects and should be considered illustrative. The scope of the embodiment should be determined by reasonable interpretation of the appended claims, and all changes within the equivalent range of the embodiment are included in the scope of the embodiment.

While various embodiments are described herein, it should be understood that they have been presented by way of example only, and not limitation. Thus, the breadth and scope of this disclosure should not be limited by any of the above-described exemplary embodiments. Moreover, any combination of the above-described elements in all possible variations thereof is encompassed by the disclosure unless otherwise indicated herein or otherwise clearly contradicted by context.

Additionally, while the processes described above and illustrated in the drawings are shown as a sequence of steps, this was done solely for the sake of illustration. Accordingly, it is contemplated that some steps may be added, some steps may be omitted, the order of the steps may be re-arranged, and some steps may be performed in parallel.

## Claims

1. A power semiconductor module (100A, 100B, 100C) comprising:
a first substrate (210); and
a second substrate (220) formed over the first substrate;
**characterized by**:
a conductive member (230) disposed between the first substrate and the second substrate;
a first power semiconductor device (240) disposed between the first substrate and the conductive member; and
a second power semiconductor device (250) disposed between the conductive member and the second substrate,
wherein the conductive member is electrically connected to the first power semiconductor device and the second power semiconductor device.

2. The power semiconductor module of claim 1, wherein the first power semiconductor device and the second power semiconductor device at least partially overlap.

3. The power semiconductor module of claim 1 or 2, wherein the first power semiconductor device and the second power semiconductor device are electrically connected in series.

4. The power semiconductor module of any one of the preceding claims, wherein
the conductive member comprises:
a second part (232); and
a connection part (233) connected to the second part, and
the second power semiconductor device is disposed on a surface of the second part.

5. The power semiconductor module of claim 4, wherein the conductive member comprises:
a first part (231) positioned lower than the second part and connected to the connection part,
the conductive member includes a recess (235) formed by the first part, the connection part and the second part, and
the first power semiconductor device is disposed within the recess.

6. The power semiconductor module of any one of the preceding claims, further comprising a spacer (260) disposed between the first power semiconductor device and the conductive member.

7. The power semiconductor module of any one of the preceding claims, wherein
the first power semiconductor device comprises a first gate electrode (241), a first source electrode (242), and a first drain electrode (243),
the first gate electrode is electrically connected to the first substrate using a wire (290),
the first source electrode is electrically connected to the conductive member, and
the first drain electrode is electrically connected to the first substrate.

8. The power semiconductor module of claim 7 in combination with claim 6, wherein an upper surface of the spacer is at a higher position as compared to a position of the uppermost side of the wire.

9. The power semiconductor module of claim 7 or 8, wherein the conductive member includes an opening (236) via which the wire is disposed.

10. The power semiconductor module of any one of the preceding claims, wherein
the second power semiconductor device comprises a second gate electrode (251), a second source electrode (252), and a second drain electrode (253),
the second gate electrode and the second source electrode are electrically connected to the second substrate, and
the second drain electrode is electrically connected to the conductive member.

11. The power semiconductor module of any one of the preceding claims, comprising:
a plurality of first power semiconductor devices (240 and 245) including the first power semiconductor device,
wherein the plurality of first power semiconductor devices are connected in parallel between the first substrate and the conductive member.

12. The power semiconductor module of claim 11, comprising:
a plurality of second power semiconductor devices (250 and 255) including the second power semiconductor device,
wherein the plurality of second power semiconductor devices are connected in parallel between the conductive member and the second substrate.

13. The power semiconductor module of any one of the preceding claims, wherein a current path is configured to be formed through the first substrate, the first power semiconductor device, the conductive member, the second power semiconductor device, and the second substrate in a sequence of the first substrate, the first power semiconductor device, the conductive member, the second power semiconductor device, and the second substrate.

14. A method of forming a power semiconductor module (100A, 100B, 100C), the method comprising:
forming a first substrate (210);
forming a first power semiconductor device (240) on the first substrate;
forming a conductive member (230) over the first power semiconductor device such that the first power semiconductor device is disposed between the first substrate and the conductive member;
forming a second power semiconductor device (250) on the conductive member;
forming a second substrate (220) over the second semiconductor member such that the second power semiconductor device is disposed between the conductive member and the second substrate, wherein
the conductive member is disposed between the first substrate and the second substrate.

15. The method of claim 14, wherein a current path is configured to be formed through the first substrate, the first power semiconductor device, the conductive member, the second power semiconductor device, and the second substrate in a sequence of the first substrate, the first power semiconductor device, the conductive member, the second power semiconductor device, and the second substrate.
